# EUROPEAN PATENT APPLICATION

(11) **EP 3 454 127 A1**
(43) Date of publication of application: **13.03.2019**
(21) Application number: 17190433.7
(22) Date of filing: 11.09.2017
(51) Int. Cl.: G03F 7/20, G03F 1/24, G21K 1/06

(54) **METHODS AND PATTERNING DEVICES AND APPARATUSES FOR MEASURING FOCUS PERFORMANCE OF A LITHOGRAPHIC APPARATUS, DEVICE MANUFACTURING METHOD**

(71) Applicant: ASML Netherlands B.V., 5500 AH Veldhoven (NL)
(72) Inventor: DE WINTER, Laurentius Cornelius, 5500 AH Veldhoven (NL); STOLK, Roland Pieter, 5500 AH Veldhoven (NL); STAALS, Frank, 5500 AH Veldhoven (NL)
(74) Representative: Peters, John Antoine

(57) **Abstract**

Disclosed is a method of measuring focus performance of a lithographic apparatus, and corresponding patterning device and lithographic apparatus. The method comprises using the lithographic apparatus to print one or more printed structures using a reflective patterning device onto a substrate. The reflective patterning device comprises first reticle structures and second reticle structures. A first angular reflectivity curve of the one or more first reticle structures is different from a second angular reflectivity curve of the one or more second reticle structures. The one or more printed structures comprise first printed structures corresponding to the first reticle structures and second printed structures corresponding to the second reticle structures. A focus dependent parameter related to a focus- dependent positional shift between the first printed structures and the second printed structures on said substrate is measured and a measurement of focus performance based on the focus dependent parameter is derived therefrom.

## Description

### Field of the Invention

0001 The present invention relates to inspection apparatus and methods usable, for example, to perform metrology in the manufacture of devices by lithographic techniques. The invention further relates to such methods for monitoring a focus parameter in a lithographic process.

### Background Art

0002 A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

0003 In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

0004 Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). Diffraction-based overlay metrology using dark-field imaging of the diffraction orders enables measurement of overlay and other parameters on smaller targets. These targets can be smaller than the illumination spot and may be surrounded by product structures on a substrate. The intensities from the environment product structures can efficiently be separated from the intensities from the overlay target with the dark-field detection in the image-plane.

0005 Examples of dark field imaging metrology can be found in international patent applications US20100328655A1 and US2011069292A1 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

0006 One important parameter of a lithographic process which requires monitoring is focus. There is a desire to integrate an ever-increasing number of electronic components in an IC. To realize this, it is necessary to decrease the size of the components and therefore to increase the resolution of the projection system, so that increasingly smaller details, or line widths, can be projected on a target portion of the substrate. As the critical dimension (CD) in lithography shrinks, consistency of focus, both across a substrate and between substrates, becomes increasingly important. CD is the dimension of a feature or features (such as the gate width of a transistor) for which variations will cause undesirable variation in physical properties of the feature.

0007 Traditionally, optimal settings were determined by "send-ahead wafers" i.e. substrates that are exposed, developed and measured in advance of a production run. In the send-ahead wafers, test structures were exposed in a so-called focus-energy matrix (FEM) and the best focus and energy (exposure dose) settings were determined from examination of those test structures. More recently, focus metrology targets are included in the production designs, to allow continuous monitoring of focus performance. These metrology targets should permit rapid measurements of focus, to allow fast performance measurement in high-volume manufacturing. Ideally, the metrology targets should be small enough that they can be placed among the product features without undue loss of space.

0008 Current test structure designs and focus measuring methods have a number of drawbacks. Known focus metrology targets require sub-resolution features and/or grating structures with large pitches. Such structures may contravene design rules of the users of lithographic apparatuses. Asymmetry in a grating structure can be measured effectively using high-speed inspection apparatus such as a scatterometer, working at visible radiation wavelengths. Known focus measuring techniques exploit the fact that focus-sensitive asymmetry can be introduced into structures printed in a resist layer by special design of the patterns on a patterning device that defines the target structure. For EUV lithography, where printing is performed using radiation of a wavelength less than 20 nm, for example 13.5 nm, the creation of sub-resolution features becomes even more difficult. For EUV lithography, resist thickness, and therefore the thickness of target structures, is smaller. This weakens the diffraction efficiency, and hence the signal strength, available for focus metrology.

0009 For these reasons, there is a need to develop new techniques for the measurement of focus performance in lithographic processes, particularly in EUV lithography, but also for projection-based lithography in general.

### SUMMARY OF THE INVENTION

0010 The present invention aims to provide alternative methods of measuring focus performance. In some aspects the invention aims to provide methods that are adaptable to new environments, such as EUV lithography. In some aspects, the invention aims to avoid the requirement for sub-resolution features to be defined in a patterning device.

0011 The invention in a first aspect provides a method of measuring focus performance of a lithographic apparatus, the method comprising: (a) using the lithographic apparatus to print one or more printed structures using at least one reflective patterning device onto a substrate, said reflective patterning device comprising one or more first reticle structures and one or more second reticle structures, wherein a first angular reflectivity curve of the one or more first reticle structures is different from a second angular reflectivity curve of the one or more second reticle structures and wherein said one or more printed structures comprise one or more first printed structures corresponding to said one or more first reticle structures and one or more second printed structures corresponding to said one or more second reticle structures; (b) measuring a focus dependent parameter related to a focus- dependent positional shift between said one or more first printed structures and said one or more second printed structures on said substrate; and (c) deriving a measurement of focus performance based at least in part on the focus dependent parameter measured in step (b).

0012 The invention in a second aspect provides a reflective patterning device one or more first reticle structures and one or more second reticle structures, wherein a first angular reflectivity curve of the one or more first reticle structures is different from a second angular reflectivity curve of the one or more second reticle structures.

0013 The invention yet further provides computer program products for use in implementing methods and apparatuses according to various aspects of the first aspect of the invention as set forth above.

0014 The invention yet further provides a method of manufacturing devices using the method according to the first aspect of the invention as set forth above.

0015 Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

0016 Embodiments of the invention will now be described, by way of example only, with reference to the accompanying schematic drawings in which corresponding reference symbols indicate corresponding parts, and in which:
Figure 1 depicts a lithographic apparatus having a reflective patterning device;
Figure 2 depicts a lithographic cell or cluster in which a lithographic apparatus and metrology apparatus can be used to perform methods according to the present invention;
Figure 3 illustrates schematically an inspection apparatus adapted to perform angle-resolved scatterometry and dark-field imaging inspection methods;
Figure 4 illustrates the formation of a focus metrology target on a substrate using a reflective patterning device in one embodiment of the present invention;
Figure 5 illustrates is an angular reflectivity curve or plot of reflectivity (y-axis) against angle (x-axis) illustrating the effect of multilayer pitch on the reflectivity characteristics of the multilayer;
Figure 6 illustrates a first example of a focus monitoring target suitable for monitoring focus using the inspection apparatus of Figure 3;
Figure 7 illustrates a second example of a focus monitoring target suitable for monitoring focus using the inspection apparatus of Figure 3; and
Figure 8 is a flowchart of a method of monitoring focus according to an embodiment of the invention;

### DETAILED DESCRIPTION OF EXEMPLARY EMBODIMENTS

0017 Before describing embodiments of the invention in detail, it is instructive to present an example environment in which embodiments of the present invention may be implemented.

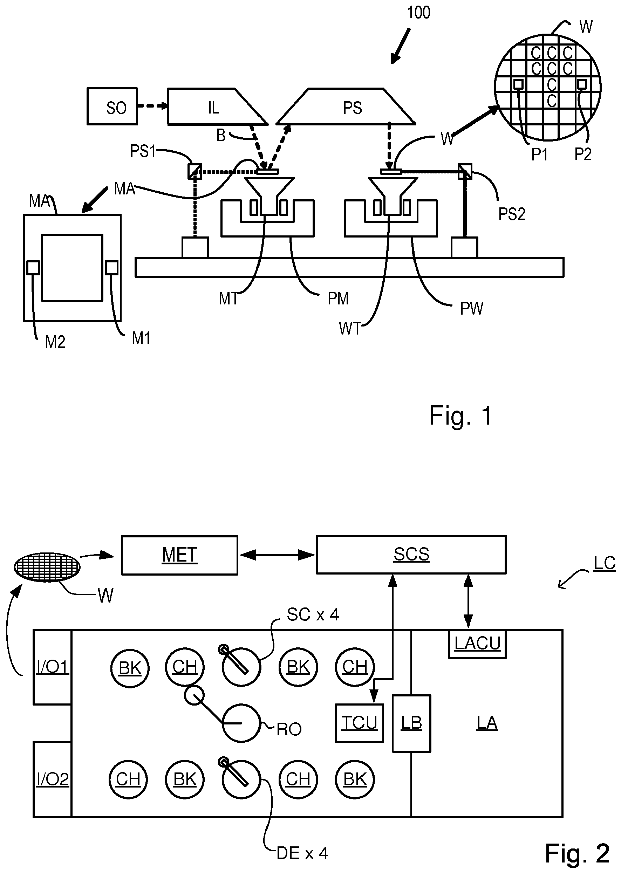

0018 Figure 1 schematically depicts a lithographic apparatus 100 including a source module SO according to one embodiment of the invention. The apparatus comprises:
- an illumination system (illuminator) IL configured to condition a radiation beam B (e.g. EUV radiation).
- a support structure (e.g. a mask table) MT constructed to support a patterning device (e.g. a mask or a reticle) MA and connected to a first positioner PM configured to accurately position the patterning device;
- a substrate table (e.g. a wafer table) WT constructed to hold a substrate (e.g. a resist-coated wafer) W and connected to a second positioner PW configured to accurately position the substrate; and
- a projection system (e.g. a reflective projection system) PS configured to project a pattern imparted to the radiation beam B by patterning device MA onto a target portion C (e.g. comprising one or more dies) of the substrate W.

0019 The illumination system may include various types of optical components, such as refractive, reflective, magnetic, electromagnetic, electrostatic or other types of optical components, or any combination thereof, for directing, shaping, or controlling radiation.

0020 The support structure MT holds the patterning device MA in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system.

0021 The term "patterning device" should be broadly interpreted as referring to any device that can be used to impart a radiation beam with a pattern in its cross-section such as to create a pattern in a target portion of the substrate. The pattern imparted to the radiation beam may correspond to a particular functional layer in a device being created in the target portion, such as an integrated circuit.

0022 In general patterning devices used in lithography may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

0023 The projection system, like the illumination system, may include various types of optical components, such as refractive, reflective, magnetic, electromagnetic, electrostatic or other types of optical components, or any combination thereof, as appropriate for the exposure radiation being used, or for other factors such as the use of a vacuum. It may be desired to use a vacuum for EUV radiation since other gases may absorb too much radiation. A vacuum environment may therefore be provided to the whole beam path with the aid of a vacuum wall and vacuum pumps.

0024 As here depicted, the apparatus is of a reflective type (e.g. employing a reflective mask). The focus metrology techniques of the present disclosure have been developed particularly for use with reflective patterning devices (reticles), where illumination is not in a direction normal to a plane of the patterning device surface, but at a slightly oblique angle. In principle, the same techniques could apply in relation to a transmissive patterning device, if for some reason illumination introduced asymmetry. Conventionally, illumination of the reticle is designed to be symmetrical, but with reflective reticles, that is not generally possible.

0025 Certain embodiments of the present disclosure exploit asymmetry in the projection system using a reflective patterning device. Other embodiments are applicable with any kind of projection system.

0026 The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

0027 Referring to Figure 1, the illuminator IL receives an extreme ultra violet radiation beam from the source module SO. Methods to produce EUV light include, but are not necessarily limited to, converting a material into a plasma state that has at least one element, e.g., xenon, lithium or tin, with one or more emission lines in the EUV range. In one such method, often termed laser produced plasma ("LPP") the required plasma can be produced by irradiating a fuel, such as a droplet, stream or cluster of material having the required line-emitting element, with a laser beam. The source module SO may be part of an EUV radiation system including a laser, not shown in Figure 1, for providing the laser beam exciting the fuel. The resulting plasma emits output radiation, e.g., EUV radiation, which is collected using a radiation collector, disposed in the source module. The laser and the source module may be separate entities, for example when a CO2 laser is used to provide the laser beam for fuel excitation.

0028 In such cases, the laser is not considered to form part of the lithographic apparatus and the radiation beam is passed from the laser to the source module with the aid of a beam delivery system comprising, for example, suitable directing mirrors and/or a beam expander. In other cases the source may be an integral part of the source module, for example when the source is a discharge produced plasma EUV generator, often termed as a DPP source.

0029 The illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross-section.

0030 The radiation beam B is incident on the patterning device (e.g., mask) MA, which is held on the support structure (e.g., mask table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of the radiation beam B. Similarly, the first positioner PM and another position sensor PS 1 can be used to accurately position the patterning device (e.g. mask) MA with respect to the path of the radiation beam B. Patterning device (e.g. mask) MA and substrate W may be aligned using mask alignment marks M1, M2 and substrate alignment marks P1, P2.

0031 The depicted apparatus could be used in at least one of the following modes:
1. In step mode, the support structure (e.g. mask table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.
2. In scan mode, the support structure (e.g. mask table) MT and the substrate table WT are scanned synchronously while a pattern imparted to the radiation beam is projected onto a target portion C (i.e. a single dynamic exposure). The velocity and direction of the substrate table WT relative to the support structure (e.g. mask table) MT may be determined by the (de-)magnification and image reversal characteristics of the projection system PS.
3. In another mode, the support structure (e.g. mask table) MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

0032 Combinations and/or variations on the above described modes of use or entirely different modes of use may also be employed.

0033 It will be understood that the lithographic apparatus is represented in Figure 1 in a highly schematic form, but that is all that is necessary for the present disclosure.

0034 As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

0035 In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly, a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

0036 Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatuses have sufficient sensitivity to make useful measurements of the latent image. Therefore, measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

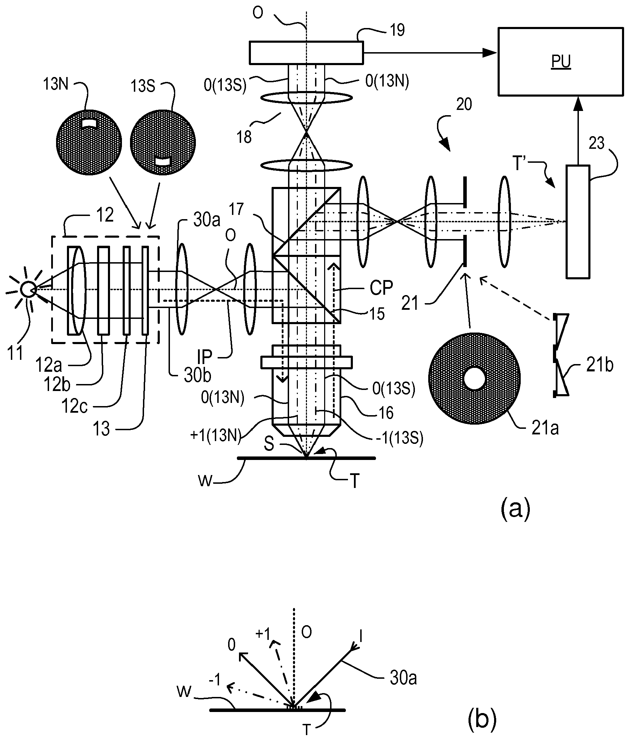

0037 Figure 3(a) shows schematically the key elements of an inspection apparatus implementing so-called dark-field imaging metrology. The apparatus may be a stand-alone device or incorporated in either the lithographic apparatus LA, e.g., at the measurement station, or the lithographic cell LC. An optical axis, which has several branches throughout the apparatus, is represented by a dotted line O. A target grating structure T and diffracted rays are illustrated in more detail in Figure 3(b).

0038 As described in the prior applications cited in the introduction, the dark-field imaging apparatus of Figure 3(a) may be part of a multi-purpose angle-resolved scatterometer that may be used instead of or in addition to a spectroscopic scatterometer. In this type of inspection apparatus, radiation emitted by a radiation source 11 is conditioned by an illumination system 12. For example, illumination system 12 may include a collimating lens system 12a, a color filter 12b, a polarizer 12c and an aperture device 13. The conditioned radiation follows an illumination path IP, in which it is reflected by partially reflecting surface 15 and focused into a spot S on substrate W via a microscope objective lens 16. A metrology target T may be formed on substrate W. Lens 16, has a high numerical aperture (NA), preferably at least 0.9 and more preferably at least 0.95. Immersion fluid can be used to obtain with numerical apertures over 1 if desired.

0039 The objective lens 16 in this example serves also to collect radiation that has been scattered by the target. Schematically, a collection path CP is shown for this returning radiation. The multi-purpose scatterometer may have two or more measurement branches in the collection path. The illustrated example as a pupil imaging branch comprising pupil imaging optical system 18 and pupil image sensor 19. An imaging branch is also shown, which will be described in more detail below. Beamsplitter 17 may divide the collected radiation between the two branches. Additionally, further optical systems and branches will be included in a practical apparatus, for example to collect reference radiation for intensity normalization, for coarse imaging of capture targets, for focusing and so forth. Details of these can be found in the prior publications mentioned above.

0040 Where a metrology target T is provided on substrate W, this may be a 1-D grating, which is printed such that after development, the bars are formed of solid resist lines. The target may be a 2-D grating, which is printed such that after development, the grating is formed of solid resist pillars or vias in the resist. The bars, pillars or vias may alternatively be etched into the substrate. Each of these gratings is an example of a target structure whose properties may be investigated using the inspection apparatus.

0041 The various components of illumination system 12 can be adjustable to implement different metrology 'recipes' within the same apparatus. In addition to selecting wavelength (color) and polarization as characteristics of the illuminating radiation, illumination system 12 can be adjusted to implement different illumination profiles. The plane of aperture device 13 is conjugate with a pupil plane of objective lens 16 and the plane of the pupil image detector 19. Therefore, an illumination profile defined by aperture device 13 defines the angular distribution of light incident on substrate W in spot S. To implement different illumination profiles, an aperture device 13 can be provided in the illumination path. The aperture device may comprise different apertures mounted on a movable slide or wheel. It may alternatively comprise a programmable spatial light modulator. As a further alternative, optical fibers may be disposed at different location in the illumination pupil plane and used selectively to deliver light or not deliver light at their respective locations. These variants are all discussed and exemplified in the documents cited above.

0042 In a first example illumination mode, aperture 13N is used and rays 30a are provided so that the angle of incidence is as shown at 'I' in Figure 3(b). The path of the zero order ray reflected by target T is labeled '0' (not to be confused with optical axis 'O'). In a second illumination mode, aperture 13S is used, so that rays 30b can be provided, in which case the angles of incidence and reflection will be swapped compared with the first mode. In Figure 3(a), the zero order rays of the first and second example illumination modes are labeled 0(13N) and 0(13S) respectively. Both of these illumination modes will be recognized as off-axis illumination modes. Many different illumination modes, including on-axis illumination modes can be implemented for different purposes.

0043 As shown in more detail in Figure 3(b), target grating T as an example of a target structure is placed with substrate W normal to the optical axis O of objective lens 16. In the case of an off-axis illumination profile, a ray of illumination I impinging on grating T from an angle off the axis O gives rise to a zeroth order ray (solid line 0) and two first order rays (dot-chain line +1 and double dot-chain line -1). It should be remembered that with an overfilled small target grating, these rays are just one of many parallel rays covering the area of the substrate including metrology target grating T and other features. Since the beam of illuminating rays 30a has a finite width (necessary to admit a useful quantity of light), the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown.

0044 In the branch of the collection path for dark-field imaging, imaging optical system 20 forms an image T' of the target on the substrate W on sensor 23 (e.g. a CCD or CMOS sensor). An aperture stop 21 is provided in a plane in the imaging branch of the collection path CP which is conjugate to a pupil plane of objective lens 16. Aperture stop 21 may also be called a pupil stop. Aperture stop 21 can take different forms, just as the illumination aperture can take different forms. The aperture stop 21, in combination with the effective aperture of lens 16, determines what portion of the scattered radiation is used to produce the image on sensor 23. Typically, aperture stop 21 functions to block the zeroth order diffracted beam so that the image of the target formed on sensor 23 is formed only from the first order beam(s). In an example where both first order beams are combined to form an image, this would be the so-called dark field image, equivalent to dark-field microscopy. As an example of an aperture stop 21, aperture 21a can be used which allows passage of on-axis radiation only. Using off-axis illumination in combination with aperture 21a, only one of the first orders is imaged at a time.

0045 The images captured by sensor 23 are output to image processor and controller PU, the function of which will depend on the particular type of measurements being performed. For the present purpose, measurements of asymmetry of the target structure are performed. Asymmetry measurements can be combined with knowledge of the target structures to obtain measurements of performance parameters of lithographic process used to form them. Performance parameters that can be measured in this way include for example overlay, focus and dose. Special designs of targets are provided to allow these measurements of different performance parameters to be made through the same basic asymmetry measurement method.

0046 Referring again to Figure 3(b) and the first example illumination mode with rays 30a, +1 order diffracted rays from the target grating will enter the objective lens 16 and contribute to the image recorded at sensor 23. When the second illumination mode is used, rays 30b are incident at an angle opposite to rays 30b, and so the -1 order diffracted rays enter the objective and contribute to the image. Aperture stop 21a blocks the zeroth order radiation when using off-axis illumination. As described in the prior publications, illumination modes can be defined with off-axis illumination in X and Y directions.

0047 By comparing images of the target grating under these different illumination modes, asymmetry measurements can be obtained. Alternatively, asymmetry measurements could be obtained by keeping the same illumination mode, but rotating the target. While off-axis illumination is shown, on-axis illumination of the targets may instead be used and a modified, off-axis aperture 21 could be used to pass substantially only one first order of diffracted light to the sensor. In a further example, a pair of off-axis prisms 21b are used in combination with an on-axis illumination mode. These prisms have the effect of diverting the +1 and -1 orders to different locations on sensor 23 so that they can be detected and compared without the need for two sequential image capture steps. This technique, is disclosed in the above-mentioned published patent application US2011102753A1, the contents of which are hereby incorporated by reference. 2nd, 3rd and higher order beams (not shown in Figure 3) can be used in measurements, instead of or in addition to the first order beams. As a further variation, the off-axis illumination mode can be kept constant, while the target itself is rotated 180 degrees beneath objective lens 16 to capture images using the opposite diffraction orders.

0048 In some embodiments of the following disclosure, techniques will be illustrated for measuring focus performance of a lithographic process that uses oblique illumination on a reflective type of patterning device. These techniques may be applied in particular in EUV lithography, where reflective optics in a near-vacuum environment are required. Metrology targets including certain focus metrology patterns will be printed on the substrate, at the same time as product features are printed. Measurement of these printed patterns may be measured using for example diffraction based techniques in the apparatus of Figure 3. To allow the use of small targets, these measurements may be performed using the dark-field imaging branch of the apparatus. Diffraction-based measurements can also be made using the pupil imaging branch, however. Of course, the apparatus shown in Figure 3 is only one example of an inspection apparatus and method that may be used to perform measurements. In one alternative, focus measurements may be made using the alignment sensor of the lithographic apparatus (scanner), for example the position sensors PS 1, PS2 of Figure 1.

0049 In the context of lithographic apparatuses working in the DUV wavelength range, targets for diffraction-based focus (DBF or µDBF) measurements have been designed and used successfully. A known type of DBF target is produced by including sub-segmented features in a grating pattern on the reticle. These features have dimensions below the imaging resolution of the lithographic apparatus, alongside more solid features. Consequently, they do not print as individual features in the resist layer on the substrate, but they influence the printing of the solid features, in a manner that is sensitive to focus error. Specifically, the presence of these features creates an asymmetric resist profile for each line in the grating within the DBF metrology target, with the degree of asymmetry being dependent upon focus. Consequently a metrology tool such as the inspection apparatus of Figure 3 can measure the degree of asymmetry from a target formed on the substrate, and translate this into the scanner focus.

0050 Unfortunately, the known DBF metrology target designs are not suitable for use in all situations. In EUV lithography, resist film thicknesses are significantly lower than those used in DUV immersion lithography, leading to low diffraction efficiency and difficulty extracting accurate asymmetry information from diffracted radiation in the scatterometer. In addition, since the resolution of the imaging system is inherently higher in EUV lithography, features having dimensions below the printing resolution of DUV immersion lithography become "solid" features printable by EUV lithography. To provide analogous sub-resolution features on an EUV reticle is rather impractical, and/or may violate semiconductor manufacturer's "design rules". Such rules are generally established as a means to restrict the feature designs to ensure the printed features conform to their process requirements. In any case, working outside the design rules makes it difficult to simulate the performance of the process on the DBF targets, so that the optimum target design and the calibration of focus measurements becomes a matter of trial-and-error. The desire to conform to design rules applies to DBF targets in DUV lithography, not only EUV lithography.

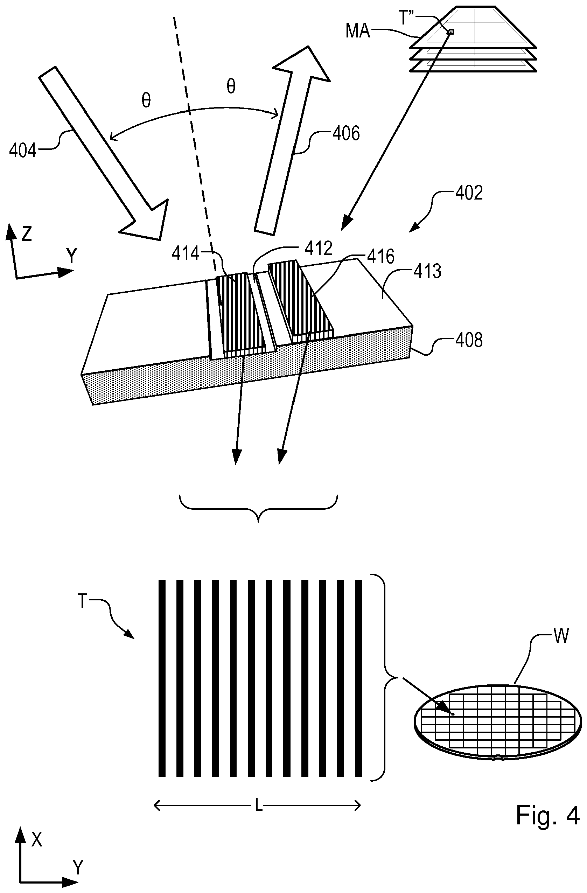

0051 Figure 4 illustrates the principles of a method of measuring focus performance of a lithographic apparatus according to the present disclosure. In the disclosed method, the lithographic apparatus is used to print at least one focus metrology pattern T on a substrate W. The printed focus metrology pattern T comprises an array of features that is periodic in at least one direction. For the purpose of this example, the focus metrology pattern T is periodic in the Y direction, which corresponds to the scanning direction of the lithographic apparatus. In a lithographic apparatus of the type described, the direction of illumination is at an oblique angle, within the Y-Z plane. The focus metrology pattern T is made periodic in this Y direction, to exploit the asymmetry in the imaging process, caused by this obliqueness of illumination. By measuring asymmetry in the printed focus metrology pattern, for example using an inspection apparatus of the type described above, a measurement of focus performance can be derived. Of course, the target T may have a different form, or be periodic in another direction, particularly when the lithographic apparatus differs from the type described.

0052 Patterning device MA comprises reflective and non-reflective portions to define features of one or more device patterns and one or more metrology patterns. As one type of metrology pattern of interest for the present disclosure, a focus metrology pattern T to be formed on the substrate W is defined by a corresponding pattern T" formed on reflective patterning device MA. An enlarged detail of part of the reticle is shown at 402. The printing operation which transfers this pattern onto a resist layer on substrate W is performed in the lithographic apparatus of Figure 1 by illuminating the reticle with EUV radiation 404 radiation incident at an oblique angle θ, which may be for example in the range of 5° to 10°. Reflected radiation 406 carrying information of the metrology target pattern (and all the product features desired to be printed on the substrate) enters the projection system PS. The basis of the reticle is a reflective structure 408, which is typically a multilayer structure, adapted to reflect a wavelength of radiation used in the lithographic apparatus. The EUV radiation is typically shorter than 20 nanometers. For example, a wavelength of approximately 13.5 nm is used in current implementations, which are based on a tin plasma radiation source.

0053 It is proposed herein to alter the reflectivity characteristics for portions of the patterning device MA. This may comprise locally altering reflectivity characteristics of the reflective structure 408 (multilayer). In particular, an angular reflectivity curve of a locally altered region may be different than the surrounding, nominal area. The multilayer 408 may comprise, for example, 40 to 50 alternating layers of silicon and molybdenum on a substrate. One method of doing this is to change (or detune) the multilayer pitch. This effectively changes the thickness of the multilayer 408 at these detuned regions. One such detuned region 412 is shown, where the multilayer pitch has been reduced and therefore the multilayer is thinner in this region (the thickness difference is exaggerated for clarity) with respect to the nominal multilayer thickness/pitch. In fact, the thickness difference with respect to nominal may be approximately 7nm, which is negligible in terms of focus (suppressed by more than a factor of 16 on wafer level) and also implies that the surroundings will be impacted only locally. The detuned multilayer results in the plane-waves of EUV radiation 404 that have, with respect to the mask-normal, either a small angle θ (when the multilayer pitch is smaller then nominal) or large angle θ (when the multilayer pitch is larger than nominal) being damped rather than reflected. In this way a non-telecentric illumination is created. This non-telecentricity can be positive or negative depending on the pitch of the multilayer 408, e.g., is it smaller or larger than nominal. The non-telecentric illumination is used to cause a lateral shift in x and/or y as function of defocus z of the aerial image of a structure on the reticle.

0054 Such a concept is analogous to the Leveling Verification Test (LVT) concept used on other, non-EUV lithographic systems. The LVT test uses a special reticle with glued glass wedges on top, to locally create non-telecentric illumination on a double telecentric lens. This non-telecentric illumination is used to cause a focus dependent shift of the aerial image of an alignment mark situated beneath a glass wedge. By measuring the alignment shift of this defocus mark with respect to a reference mark (imaged without wedge on top), the defocus at the moment of exposure can be determined. The shift is then typically measured by the alignment system present on the lithographic apparatus.

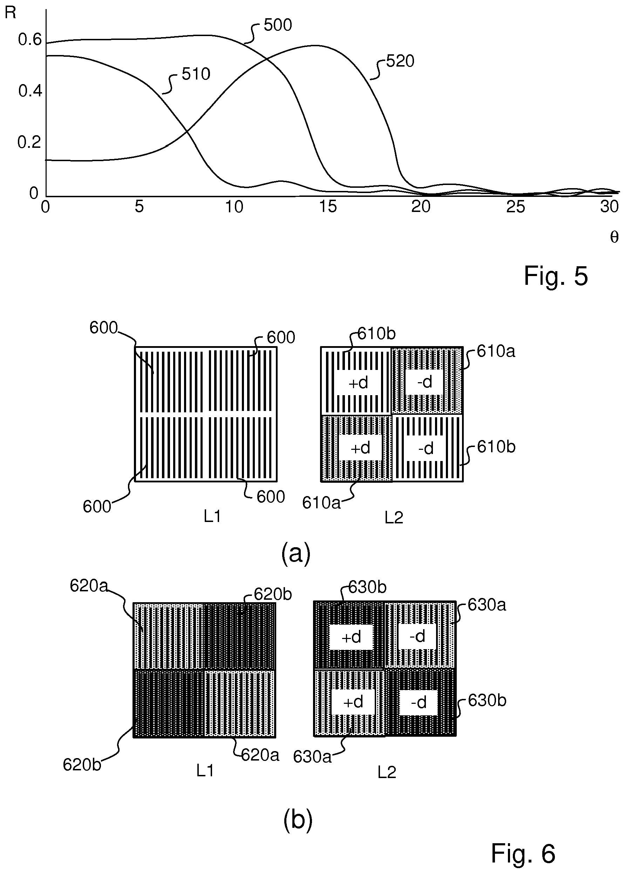

0055 Figure 5 is an angular reflectivity curve which illustrates the effect of the detuning of the multilayer 408 on reflectivity. The angular reflectivity curve is a graph of reflectivity R (where 1 is total reflection) against incidence angle θ on the reticle. Three plots are shown: a first angular reflectivity curve 500 corresponds to the nominal multilayer having a pitch tuned for optimal (e.g., substantially constant) reflectivity over the relevant angle range, i.e., θ between 0 and 11 degrees; a second angular reflectivity curve 510 corresponds to a detuned multilayer having a smaller pitch with respect to the nominal multilayer (in this specific example: 2.5% smaller); and a third angular reflectivity curve 520 corresponds to a detuned multilayer having a larger pitch with respect to the nominal multilayer (in this specific example: 2.5% larger). It can be seen that for the smaller pitch multilayer, the angular reflectivity curve 510 shows radiation incident at angles above 6 degrees being damped, and for the larger pitch multilayer, the angular reflectivity curve 520 shows radiation incident at angles below 6 degrees being damped.

0056 To translate this effect into a focus determination method usable in focus control, it is proposed, in an embodiment, to form a pattern, e.g., a first pattern 414 (e.g., a grating) on the detuned region 412, and form a second (e.g., similar) pattern 416 on the nominal area 413 of the multilayer 408. The first pattern 414 and second pattern 416 may be formed adjacent one another. Each pattern may be formed, for example, of a plurality of periodic absorber structures separated by reflective areas, which form a corresponding target T (e.g., grating) on a substrate W when exposed. The form of target T as shown is purely exemplary, and may in fact take many different forms depending on what apparatus is used to measure them and by which method.

0057 It can be shown that, due to the difference in angular reflectivity curves applicable to the first pattern 414 and second pattern 416, there will be a focus dependent shift of the first target on the substrate (imaged from first pattern 414) with respect to the second target on the substrate (imaged from second pattern 416). By measuring this focus dependent shift, the focus may be determined. It should be noted that the detuned region 412 of the multilayer should reflect sufficiently (within the relevant angle range) such that the dose remains sufficient to print features that are slightly larger than at-resolution features (e.g. the µDBO pitches- where relevant- of the targets/gratings will still print). In an embodiment, the angular reflectivity curve applicable to the detuned region 412 may result in an expected order of non-telecentricity in the resultant patterned radiation which may be in the region of 50 to 100mrad, (e.g., for larger features and a deviation of the multilayer pitch in the region of 2 to 3% from nominal).

0058 The actual relationship between focus and shift will be dependent on the actual angular reflectivity curve of the detuned region 412 (e.g., the degree of change of multilayer pitch) and the characteristics of illuminations conditions (characteristics of the measurement radiation) when performing the target measurements. As such, for a specified illumination condition, a calibration can be performed. Such a calibration step may be applicable to any of the embodiments disclosed herein. This calibration may comprise measuring (e.g., per slit position) the (relative) pattern-shifts through focus, as there is a predictable, measureable, through-slit shift. V-patterns do not shift at the slit center due to symmetry. At the slit-edge, however, due to the fact that the azimuthal angle differs from 90 degrees, the diffraction is conical. Therefore V-patterns can also be used to detect focus-variation at the slit-edge.

0059 In an embodiment, this shift may be measured using an alignment sensor of the lithographic apparatus. Such an alignment sensor could be used to directly measure a positional shift between two separate alignment targets formed in a manner described. Such adjacent targets can be assumed to have been subjected to virtually the same lithographic apparatus defocus. Only their mutual shift is relevant.

0060 However, focus measurement via pattern shifts by the alignment system may result in a throughput penalty. To avoid this, measurement of focus using the concepts described herein may be performed using a dedicated metrology apparatus such as that illustrated in Figure 3. Such a method may measure the focus from a subset of substrates, with focus corrections determined and fed back to the lithographic apparatus accordingly to maintain focus within a specified tolerance. However, suitable targets are required to be compatible with such metrology apparatuses. In particular, it may be preferable to use targets which can be measured using dark-field imaging techniques, which rely on a measurement of target asymmetry in a single target. Therefore, instead of measuring a pattern shift between adjacent targets, the target may be designed such that the structure on the reticle results in an induced focus dependent asymmetry in the target.

0061 Figure 6 shows a possible dark-field target design which enables measurement of focus change between two layers. The principle is similar to µDBO (micro- diffraction based overlay) targets for measuring overlay. A typical µDBO may comprise a first layer having two gratings of a first orientation (e.g., horizontal) and two gratings of a second orientation (e.g., vertical) and a second layer overlaid on the first layer such that each grating is overlaid with a correspondingly oriented grating to form four (compound) sub-targets. Each sub-target has a deliberate positional offset or bias between the layers, with each sub-target of a different orientation having a different bias. More specifically, each bias may have the same magnitude d, such that each pair of sub-targets of a single orientation comprise a sub-target with magnitude +d and a sub-target with magnitude -d.

0062 By comparison, in the embodiment of Figure 6(a), the target may comprise four gratings of a single orientation (e.g., oriented horizontally, vertically or 45 degree diagonally). Layer L1 comprises four gratings 600, all formed with normal (telecentric) illumination. Layer L2 is applied with +d and -d biases as before, and additionally with one each of the +d and -d biased gratings 610a being exposed with non-telecentric illumination e.g., from structures formed on detuned regions of the reticle (shown shaded), the other two gratings 610b in layer L2 being exposed with normal illumination. Measurement of focus can be determined from an intensity asymmetry measurement on the sub-targets having a non-telecentrically exposed grating 610a, in a similar manner as typically performed for measurement of diffraction based overlay or earlier diffraction based focus techniques (e.g., using the methodology described in relation to Figure 3(b)). The real overlay can be determined from sub targets having only telecentrically exposed gratings 600, 610b in the normal manner. Because of their spatial proximity, the sub-targets having a non-telecentrically exposed grating 610a and the sub targets having only telecentrically exposed gratings 600, 610b will effectively have the same pattern shift such that, when comparing layer L1 and layer L2, the focus determination can be corrected for this real overlay impact.

0063 Figure 6(b) shows a variation which enhances the signal by oppositely detuning the multilayer in the +d and -d gratings. In this embodiment, all the gratings in both layers L1 and L2 are exposed with non-telecentric illumination. The four sub-targets comprise: a first sub-target comprising a layer L1 grating exposed via a first detuned region 620a (lighter shaded) and a layer L2 grating exposed with a +d offset via a second detuned region 630b (darker shaded); a second sub-target comprising a layer L1 grating exposed via a second detuned region 620b and a layer L2 grating exposed with a -d offset via a first detuned region 630a; a third sub-target comprising a layer L1 grating exposed via a second detuned region 620b and a layer L2 grating exposed with a +d offset via a first detuned region 630a; and a fourth sub-target comprising a layer L1 grating exposed via a first detuned region 620a and a layer L2 grating exposed with a -d offset via a second detuned region 630b. The reflectivity of the first detuned regions and second detuned regions are different. More specifically, the first detuned region may comprise a positively detuned multilayer (increased pitch) and the second detuned region may comprise a negatively detuned multilayer (decreased pitch) relative to nominal. This is analogous to the double-wedge LVT method. Determining the focus from intensity asymmetry measurements of the pair of first and fourth sub-targets; and of the pair of second and third sub-targets enables overlay to be cancelled.

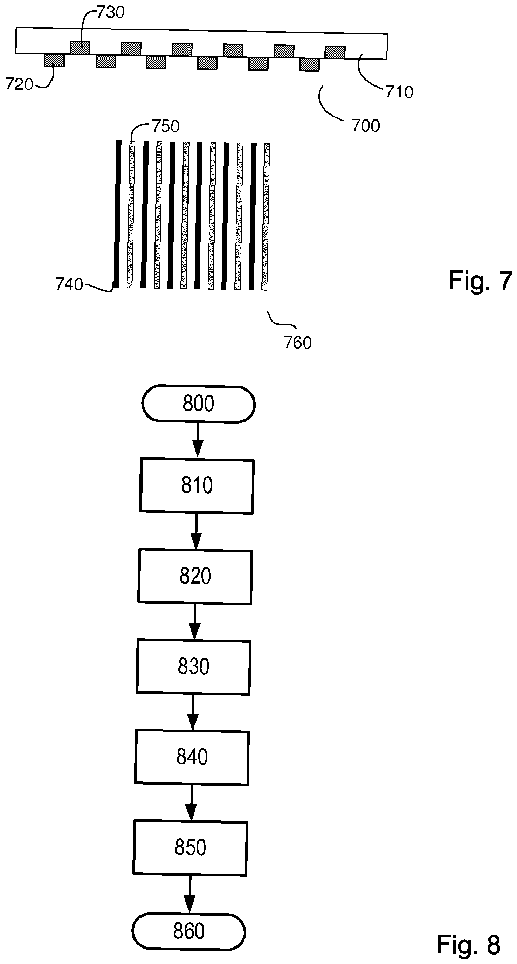

0064 It may be desirable to determine focus using a metrology apparatus such as that illustrated in Figure 3, but in a single layer. In one embodiment, illustrated in Figure 7, a reticle pattern 700 may be formed on a detuned region 710 of the reticle which comprises a combination of absorber features 720 (e.g., absorber lines) and embedded (etched) features 730 (e.g., etched lines). In particular the structure may comprise a grating of alternating absorber features 720 and embedded features 730. On a detuned region, the normal absorber features 720 result in much more non-telecentricity (e.g., a different angular reflectivity curve) compared to the embedded features 730. As a result, first lines 740 (shown darker in the drawing) formed from the absorber features 720 show a significantly greater shift as a function of focus compared to second lines 750 (shown lighter in the drawing) formed from the embedded features 730. Because of this focus-dependent relative shift between first lines 740 and second lines 750, measured asymmetry of such a printed target 760 comprising alternating first lines 750 and second lines 760 will be focus dependent. Therefore focus can be determined using an intensity asymmetry measurement of a single layer target 760 in a similar manner to a µDBF measurement.

0065 Other single-layer focus monitoring solutions may comprise optimizing the accuracy of the positioning of the metrology apparatus sensor, designing a grating having a diffraction spectrum that results in a different non-telecentricity, or having the different features (telecentrically and non-telecentrically exposed) within the field-of-view of the sensor.

0066 One method of locally altering the reflectivity of the multilayer may comprise locally heating the multilayer; e.g., by locally heating the backside of the reticle. This can cause a shrinking of the multilayer thickness, and therefore pitch at the heating location. The detuned regions may be small, e.g., in the region of a few µm square; and therefore may be located in a border region and/or scribe lane.

0067 Figure 8 is a flowchart of the steps of a method for measuring focus performance of a lithographic process according to an exemplary embodiment:
800- Start by defining a product design or metrology wafer design with printed structures, and preparing a suitable set of patterning devices (reticles). The reticles should be designed and prepared according to any of the embodiments described herein, and therefore comprise one or more detuned regions, e.g., having a detuned multilayer, on which a first reticle structure (e.g., focus metrology pattern) is formed by (for example) absorber. In addition the reticle should have one or more second (reference) reticle structures, e.g., a focus metrology pattern on a nominal area of the multilayer, or etched/embedded into the one or more detuned regions.
810- In advance of production, make exposures with known focus-exposure variations and measure any corresponding focus-induced shift of the first printed structures corresponding to the first reticle structures relative to second printed structures corresponding to the second reticle structures, to obtain one or more calibration curves. (This may involve an iterative loop of design, exposure and measurement steps.)
820- During production, print one or more first printed structures from said first reticle structures and one or more second printed structures from said second reticle structures, alongside product patterns on a substrate;
830- Measure a positional shift between the first printed structures and the second printed structures. This step may comprise using an alignment sensor to measure a shift between a first target (the first printed structure) and second target (the second printed structure) Alternatively, this step may comprise using a metrology apparatus such as illustrated in Figure 3(a) to measure targets as illustrated in Figure 6 and/or Figure 7 (each comprising examples of said first and second printed structures). Such a method may comprise measuring intensity asymmetry by the following steps:
   i. Measure intensity of a portion of the diffraction spectrum of each printed structure using a suitable inspection apparatus (for example the +1 order is a suitable portion of the diffraction spectrum);
   ii. Measure intensity of an opposite portion of the diffraction spectrum (for example, -1 order) of each printed structure using the inspection apparatus;
   iii. Calculate measurements of asymmetry of one or more printed structures by comparing the intensities (e.g., determining the intensity difference) of the opposite diffraction orders;
840- Using the measurements from step 830, with the calibration curves stored in step 810, calculate focus error at the time of printing the printed structure(s).
850- Use the derived focus measurement in focus setting for exposures on subsequent substrates.
860- End or repeat.

0068 In conclusion, a method of manufacturing devices using the lithographic process can be improved by performing focus measurement methods as disclosed herein, using it to measure processed substrates to measure parameters of performance of the lithographic process, and adjusting parameters of the process (particularly focus) to improve or maintain performance of the lithographic process for the processing of subsequent substrates.

0069 While the target structures including and focus metrology patterns described above are metrology targets specifically designed and formed for the purposes of measurement, in other embodiments, properties may be measured on targets which are functional parts of devices formed on the substrate. Many devices have regular, grating-like structures. The terms "metrology pattern" and "metrology target" and the like as used herein do not require that the structure has been provided specifically for the measurement being performed.

0070 The substrates on which these metrology patterns are formed may be production wafers or experimental wafers in product development. They may also be dedicated metrology wafers, for example monitor wafers which are processed intermittently as part of an advance process control (APC) mechanism.

0071 In association with the physical grating structures defining the focus metrology targets as realized on substrates and patterning devices, an embodiment may include a computer program containing one or more sequences of machine-readable instructions describing a method of designing focus metrology patterns, metrology recipes and/or controlling the inspection apparatus to implement the illumination modes and other aspects of those metrology recipes. This computer program may be executed for example in a separate computer system employed for the design/control process. As mentioned, calculations and control steps may be wholly or partly performed within unit PU in the apparatus of Figure 3, and/or the control unit LACU of Figure 2. There may also be provided a data storage medium (e.g., semiconductor memory, magnetic or optical disk) having such a computer program stored therein.

0072 Further embodiments of the invention are disclosed in the list of numbered embodiments below:
1. A method of measuring focus performance of a lithographic apparatus, the method comprising:
   (a) using the lithographic apparatus to print one or more printed structures using at least one reflective patterning device onto a substrate, said reflective patterning device comprising one or more first reticle structures and one or more second reticle structures, wherein a first angular reflectivity curve of the one or more first reticle structures is different from a second angular reflectivity curve of the one or more second reticle structures and wherein said one or more printed structures comprise one or more first printed structures corresponding to said one or more first reticle structures and one or more second printed structures corresponding to said one or more second reticle structures;
   (b) measuring a focus dependent parameter related to a focus- dependent positional shift between said one or more first printed structures and said one or more second printed structures on said substrate; and
   (c) deriving a measurement of focus performance based at least in part on the focus dependent parameter measured in step (b).
2. A method according to embodiment 1, wherein each angular reflectivity curve describes a variation of reflectivity of the corresponding structure and/or region with angles of incidence on said structure and/or region of patterning radiation used in said printing of the one or more printed structures; wherein said patterning radiation is used to print said one or more first printed structures and said one or more second printed structures.
3. A method according to embodiment 1 or 2, wherein said reflective patterning device comprises a reflective multilayer surface, having at least one detuned region of said reflective multilayer surface which has an altered multilayer pitch such that the angular reflectivity curve of the detuned region is different to a nominal region of the reflective multilayer surface.
4. A method according to embodiment 3, wherein said measuring step is performed using an alignment sensor of the lithographic apparatus.
5. A method according to embodiment 4, wherein the first printed structure comprises a first alignment target and said second printed structure comprises a second alignment target, and wherein said one or more first reticle structures are located on the detuned region of said patterning device and said one or more second reticle structures are located on the nominal region of said patterning device.
6. A method according to embodiment 3, wherein said measuring step is performed using a metrology apparatus which measures intensity asymmetry in corresponding higher orders of diffracted radiation, said intensity asymmetry corresponding to asymmetry in a printed structure being measured.
7. A method according to embodiment 6, wherein said one or more first reticle structures and one or more second reticle structures are both located on the detuned region, said one or more first reticle structures being formed of an absorber material on the reticle's reflective surface and said one or more second reticle structures being embedded in the reticle's reflective surface.
8. A method according to embodiment 7, wherein said one or more first reticle structures form a first periodic structure and said one or more second reticle structures form a second periodic structure which is interlaced with said first periodic structure such that said first periodic structure and second period structure form a single printed metrology target in step (a) comprising said one or more printed structures and which has focus dependent asymmetry.
9. A method according to embodiment 6, wherein said one or more first reticle structures are printed on the substrate in a first layer and said one or more second reticle structures are printed on the substrate in a second layer, overlaying said first layer to form a printed metrology target which has focus dependent asymmetry.
10. A method according to embodiment 9, wherein said one or more first reticle structures are located on the detuned region of a first patterning device and said one or more second reticle structures are located on the nominal region of a second patterning device.
11. A method according to embodiment 9, wherein said one or more first reticle structures are located on a first detuned region of a first patterning device and said one or more second reticle structures are located on a second detuned region of a second patterning device; and wherein said first detuned region has a different angular reflectivity curve to said second detuned region.
12. A method according to embodiment 10 or 11, wherein said second printed structures are overlaid said first printed structures with a deliberate positional bias to enable measurement and/or cancellation of overlay.
13. A method according to any of embodiments 3 to 12, wherein the angular reflectivity curve of the nominal region is shows less variation with angle of incidence over a range of angles of incidence used in printing of said one or more printed structures compared to the angular reflectivity curve(s) of the one or more nominal regions.
14. A method according to embodiment 13, wherein the angular reflectivity curve of the nominal region is shows substantially constant reflectivity with angle of incidence over a range of angles of incidence used in printing of said one or more printed structures.
15. A method according to any preceding embodiment, comprising an initial calibration stage to determine the relationship between the focus dependent parameter and focus for the particular lithographic apparatus settings and patterning device used in step (b).
16. A reflective patterning device comprising one or more first reticle structures and one or more second reticle structures, wherein a first angular reflectivity curve of the one or more first reticle structures is different from a second angular reflectivity curve of the one or more second reticle structures.
17. A reflective patterning device according to embodiment 16, wherein each angular reflectivity curve describes a variation of reflectivity of the corresponding structure and/or region with angles of incidence on said structure and/or region of patterning radiation used in said printing of the one or more printed structures; wherein said patterning radiation is used to print said one or more first printed structures and said one or more second printed structures.
18. A reflective patterning device according to embodiment 16 or 17, comprising a reflective multilayer surface, having at least one detuned region of said reflective multilayer surface which has an altered multilayer pitch such that the angular reflectivity curve of the detuned region is different to a nominal region of the reflective multilayer surface.
19. A reflective patterning device according to embodiment 18, wherein the one or more first reticle structures corresponds to a first alignment target and the one or more second reticle structures corresponds to a second alignment target, and wherein said one or more first reticle structures are located on the detuned region of said patterning device and said one or more second reticle structures are located on the nominal region of said patterning device.
20. A reflective patterning device according to embodiment 18, wherein said one or more first reticle structures and one or more second reticle structures are both located on said at least one detuned region, said one or more first reticle structures being formed of an absorber material on the reticle's reflective surface and said one or more second reticle structures being embedded in the reticle's reflective surface.
21. A metrology apparatus for measuring a parameter of a lithographic process, the metrology apparatus being operable to perform steps (b) and (c) of the method of any of embodiments 1 to 15.
22. A lithographic system comprising:
   a lithographic apparatus comprising:
      an illumination optical system arranged to illuminate a reflective patterning device;
      a projection optical system arranged to project an image of the patterning device onto a substrate; and
      a metrology apparatus according to embodiment 21
      wherein the lithographic apparatus is arranged to use the measurement of focus performance derived by the metrology apparatus when applying the pattern to further substrates.
23. A computer program comprising processor readable instructions which, when run on suitable processor controlled apparatus, cause the processor controlled apparatus to perform steps (b) and/or (c) the method of any of embodiments 1 to 15.
24. A method of manufacturing devices wherein a device pattern is applied to a series of substrates using a lithographic process, the method including:
   - using the method of any of embodiments 1 to 15 to measure focus performance of the lithographic process, and controlling the lithographic process for later substrates in accordance with the measured focus performance.

0073 The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

0074 The term "lens", where the context allows, may refer to any one or combination of various types of optical components, including refractive, reflective, magnetic, electromagnetic and electrostatic optical components.

0075 The breadth and scope of the present invention should not be limited by any of the above-described exemplary embodiments, but should be defined only in accordance with the following claims and their equivalents.

## Claims

1. A method of measuring focus performance of a lithographic apparatus, the method comprising:
(a) using the lithographic apparatus to print one or more printed structures using at least one reflective patterning device onto a substrate, said reflective patterning device comprising one or more first reticle structures and one or more second reticle structures, wherein a first angular reflectivity curve of the one or more first reticle structures is different from a second angular reflectivity curve of the one or more second reticle structures and wherein said one or more printed structures comprise one or more first printed structures corresponding to said one or more first reticle structures and one or more second printed structures corresponding to said one or more second reticle structures;
(b) measuring a focus dependent parameter related to a focus- dependent positional shift between said one or more first printed structures and said one or more second printed structures on said substrate; and
(c) deriving a measurement of focus performance based at least in part on the focus dependent parameter measured in step (b).

2. A method as claimed in claim 1, wherein each angular reflectivity curve describes a variation of reflectivity of the corresponding structure and/or region with angles of incidence on said structure and/or region of patterning radiation used in said printing of the one or more printed structures; wherein said patterning radiation is used to print said one or more first printed structures and said one or more second printed structures.

3. A method as claimed in claim 1 or 2, wherein said reflective patterning device comprises a reflective multilayer surface, having at least one detuned region of said reflective multilayer surface which has an altered multilayer pitch such that the angular reflectivity curve of the detuned region is different to a nominal region of the reflective multilayer surface.

4. A method as claimed in claim 3, wherein said measuring step is performed using an alignment sensor of the lithographic apparatus.

5. A method as claimed in claim 4, wherein the first printed structure comprises a first alignment target and said second printed structure comprises a second alignment target, and wherein said one or more first reticle structures are located on the detuned region of said patterning device and said one or more second reticle structures are located on the nominal region of said patterning device.

6. A method as claimed in claim 3, wherein said measuring step is performed using a metrology apparatus which measures intensity asymmetry in corresponding higher orders of diffracted radiation, said intensity asymmetry corresponding to asymmetry in a printed structure being measured.

7. A method as claimed in claim 6, wherein said one or more first reticle structures and one or more second reticle structures are both located on the detuned region, said one or more first reticle structures being formed of an absorber material on the reticle's reflective surface and said one or more second reticle structures being embedded in the reticle's reflective surface.

8. A method as claimed in claim 7, wherein said one or more first reticle structures form a first periodic structure and said one or more second reticle structures form a second periodic structure which is interlaced with said first periodic structure such that said first periodic structure and second period structure form a single printed metrology target in step (a) comprising said one or more printed structures and which has focus dependent asymmetry.

9. A method as claimed in claim 6, wherein said one or more first reticle structures are printed on the substrate in a first layer and said one or more second reticle structures are printed on the substrate in a second layer, overlaying said first layer to form a printed metrology target which has focus dependent asymmetry.

10. A method as claimed in claim 9, wherein said one or more first reticle structures are located on the detuned region of a first patterning device and said one or more second reticle structures are located on the nominal region of a second patterning device.

11. A method as claimed in claim 9, wherein said one or more first reticle structures are located on a first detuned region of a first patterning device and said one or more second reticle structures are located on a second detuned region of a second patterning device; and wherein said first detuned region has a different angular reflectivity curve to said second detuned region.

12. A method as claimed in claim 10 or 11, wherein said second printed structures are overlaid said first printed structures with a deliberate positional bias to enable measurement and/or cancellation of overlay.

13. A reflective patterning device comprising one or more first reticle structures and one or more second reticle structures, wherein a first angular reflectivity curve of the one or more first reticle structures is different from a second angular reflectivity curve of the one or more second reticle structures.

14. A reflective patterning device as claimed in claim 13, wherein each angular reflectivity curve describes a variation of reflectivity of the corresponding structure and/or region with angles of incidence on said structure and/or region of patterning radiation used in said printing of the one or more printed structures; wherein said patterning radiation is used to print said one or more first printed structures and said one or more second printed structures.

15. A reflective patterning device as claimed in claim 13 or 14, comprising a reflective multilayer surface, having at least one detuned region of said reflective multilayer surface which has an altered multilayer pitch such that the angular reflectivity curve of the detuned region is different to a nominal region of the reflective multilayer surface.
